# EUROPEAN PATENT APPLICATION

(11) **EP 2 405 727 A1**
(43) Date of publication of application: **11.01.2012**
(21) Application number: 10758228.0
(22) Date of filing: 26.03.2010
(51) Int. Cl.: H05K 3/46, H01L 23/12

(54) **MANUFACTURING METHOD FOR CIRCUIT BOARD, AND CIRCUIT BOARD**

(30) Priority: 02.04.2009 JP 2009089907
(71) Applicant: Panasonic Corporation, Kadoma-shi Osaka 571-8501 (JP)
(72) Inventor: KITA, Takayuki, Osaka 540-6207 (JP)
(74) Representative: Grünecker, Kinkeldey, Stockmair & Schwanhäusser
(86) International application number: PCT/JP2010/002183
(87) International publication number: WO 2010/113448

(57) **Abstract**

A method of manufacturing circuit boards includes the steps of forming an upper board having an opening, and provided with a circuit and an insulating film layer formed on a surface thereof, forming a lower board provided with a circuit and an insulating film layer formed on a surface thereof, forming an inter-board connecting sheet having a through-hole filled with a conductive paste, and layering the lower board, the inter-board connecting sheet and the upper board together, and applying heat and pressure. The step of forming the lower board includes a step of forming the insulating film layer into a shape leaving a clearance provided between an end of the film layer and any of an end of the opening of the upper board and an end of an opening of the inter-board connecting sheet when these three items are layered together, and the step of applying heat and pressure includes a step of inserting a cushion member into the openings of the inter-board connecting sheet and the upper board and into the clearance.

## Description

### Technical Field

The present invention relates to a method for manufacturing a multi-layer circuit board having a cavity structure, in which semiconductors or other components can be mounted, and it also relates to the same circuit board.

### Background Art

In recent years, electronic devices have been downsized and sophisticated. This trend has required circuit boards, on which electronic circuits for the electronic device are mounted, to accommodate a greater amount of wirings. To increase a packaging density in particular, a circuit board, to which semiconductors and other components are mounted, is further mounted on a multilayer printed circuit board, which is thus referred to as a mother board. Use of this type of circuit board has been increased.

The LTCC (Low Temperature Co-fired Ceramics) is spotlighted because it allows reducing a height of a circuit board already mounted with components. A multilayer structure having a three dimensional cavity structure formed by molding resin or a component built-in structure has also drawn attention in the industry. Those structures are employed in small electronic devices such as portable phones, digital still cameras, or in mounting various modules including RF, electronic components related to LED.

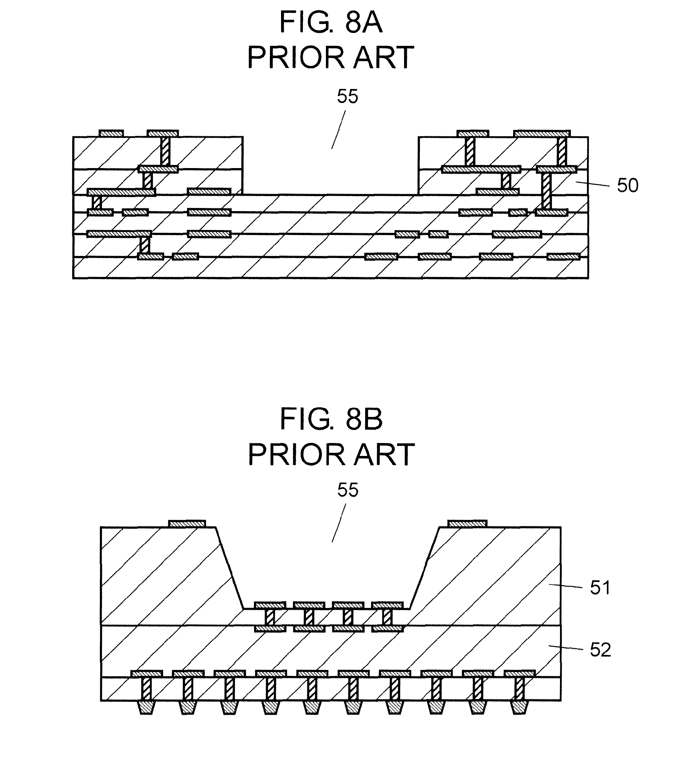

Fig. 8A shows a sectional view of a conventional circuit board made of ceramics. A conventional ceramic board including an LTCC is a multilayer circuit board as shown in Fig. 8A. The ceramic board is formed this way: Laminate multiple green sheets 50 each of which is made of ceramic board provided with a wiring conductor, and some of which green sheets include vias punched through or openings 55 to be cavities, then bake green sheets 50. The baking is regularly done at 900°C or lower in the case of LTCC, and at 1000°C or lower in the case of glass ceramic board.

Fig. 8B is a sectional view of a conventional circuit board made of resin. This conventional three-dimensional and multilayer circuit board is formed this way: Form mold-resin layer 51 on lower board 52, and hot-melt the resin with a tooling die, and then form a wiring circuit on the surface of the melted resin by plating.

The foregoing ceramic board, however, needs to undergo the baking at as high as 900°C even in the case of LTCC, so that the green sheets are obliged to be contracted. It is thus difficult to maintain dimensional accuracy and accuracy in the circuits. On top of that, this structure including the cavity structure needs a longer manufacturing lead-time, and its manufacturing cost is rather expensive.

In the case of multilayer circuit boards having a cavity structure formed by molding resin, a conductive hole formed prior to the molding can be deformed by a resin flow during the molding, so that this conductive hole will invite deterioration in insulation between circuits or shorts between the circuits. The interlayer connection technique employing inner via holes (IVH) throughout the layers thus encounters problems in process or in structure. To overcome these problems, a non-through hole or a through-hole is formed after the mold resin, and then a conductive hole is formed by conductive plating or with conductive material. However, this method is not good at a hole of small diameter, so that it cannot be used for fulfilling a micro-dimensional specification that has been demanded recently in the industry.

The expansion coefficient of the foregoing ceramic board or the circuit board made by molding resin is greatly different from that of a mother board on which the ceramic board or the like is mounted. The mounting of these boards onto the mother board is thus restricted by various conditions.

To overcome the foregoing problem, a multilayer printed circuit board working as a mother board is layered thereon with multiple circuit boards made of the same material as this mother board by using bonding layers such as prepreg sheets. This kind of multilayer circuit board having a cavity structure is also developed. These techniques are disclosed in, e.g. Patent Literature 1 and Patent Literature 2.

The multilayer circuit board employing the prepreg sheets can maintain the bonding strength between the boards; however, the resin flows out from the prepreg sheets (bonding layers) into the cavities during an application of heat and pressure. A problem thus may happen when a component is mounted in the cavity. The flow of resin, i.e. the same problem as the forgoing circuit board made by molding resin, thus makes it difficult to employ the IVH technique throughout the layers from the standpoint of structure and manufacturing process.

The board having the cavity structure among others is required to be smaller and lower in size as well as to have narrower wirings. At an upper section of the cavity, in particular, a distance between a cavity wall and a connection land existing around the wall is strongly required to be shorter for downsizing the board.

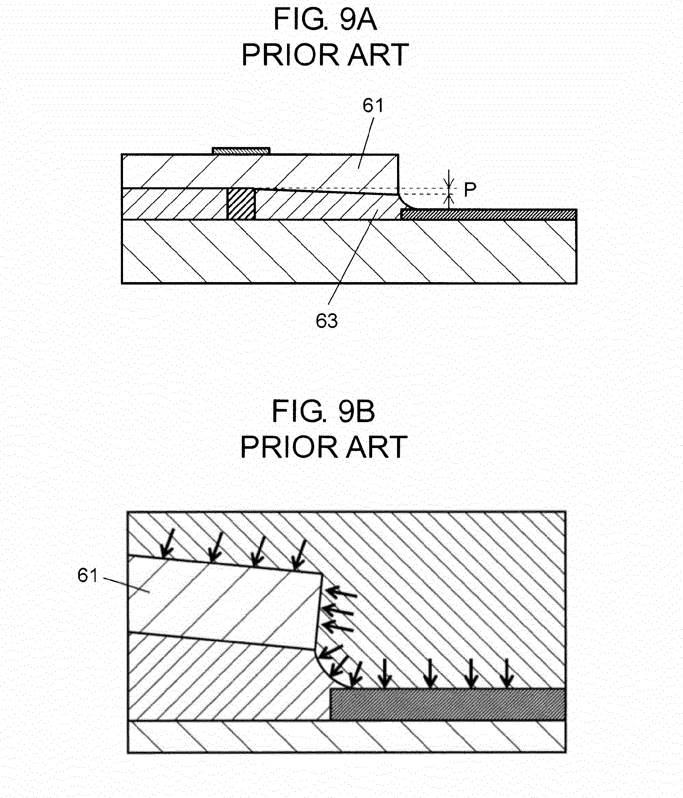

Fig. 9A and Fig. 9B are sectional views illustrating problems of the conventional circuit board and problems in manufacturing the conventional circuit board. Deflection amount P of upper board 61 is affected by a layer structure or a residual copper rate of designed pattern, so that it is hard to intentionally regulate the deflection amount in an actual product specification or during an actual manufacturing process.

Here is another measure to the conventional problems: Make an opening area of a bonding layer smaller relative to an opening area of the upper board. However, this method makes a bottom area of the cavity smaller due to a width where the resin oozes from the bonding layer, so that a greater restriction should be taken into account in designing, and on top of that, this problem goes against the foregoing demand from the industry. This measure thus cannot be a practical solution.

As shown in Figs. 9A and 9B, the resin flows out from bonding layer 63 during the application of heat and pressure, and upper board 61 sometimes produces deflection.

### Related Art Literature

Patent Literature 1: Unexamined Japanese Patent Application Publication No. H09 - 199824
Patent Literature 2: Unexamined Japanese Patent Application Publication No. 200 i - 59844

### Disclosure of Invention

A method for manufacturing a circuit board of the present invention comprises the steps of:
forming an upper board having an opening, and provided with a circuit and an insulating film layer formed on a surface thereof;
forming a lower board provided with a circuit and an insulating film layer formed on a surface thereof;
forming an inter-board connecting sheet having a through-hole filled with a conductive paste ; and
layering the lower board, the inter-board connecting sheet, and the upper board together and applying heat and pressure.

In the step of forming the lower board, forming the insulating film layer into a shape leaving a clearance provided between an end of the film layer and any of an end of the opening of the upper board and an end of an opening of the inter-board connecting sheet when these three items are layered together.

The step of applying heat and pressure includes a step of inserting cushion members into the openings of the inter-board connecting sheet and the upper board and into the clearance.

The foregoing method and structure allows preventing the resin flowing out from an end face of the inter-board connecting sheet as well as preventing a conductive hole from being deformed due to, e.g. via-collapse, while the upper board is maintained free from deflection. As a result, the circuit board having a recessed cavity section and an IVH structure throughout the layers can be manufactured efficiently with highly reliable inter-layer connections.

A circuit board of the present invention comprises the following structural elements:
an upper board having an opening, and provided with a circuit and an insulating film layer on a surface thereof;
a lower board provided with a circuit and an insulating film layer on a surface thereof; and
an inter-board connecting sheet including an opening and a conductive hole for inter-layer connection.

The lower board and the upper board are layered together with the inter-board connecting sheet placed therebetween such that the opening of the upper board and the opening of the sheet can form a cavity. The opening of the sheet has a greater area than that of the opening of the upper board. A clearance is provided between an end of insulating film layer of the lower board and an end of the opening of the inter-board connecting sheet.

The foregoing structure allows preparing a flowing path of mold resin, to be used in mounting a semiconductor, on a bottom of the cavity, so that external moisture can be prevented from entering. As a result, the electric insulation in high temperature and high humidity can be maintained or enhanced, and the reliability of mounting the semiconductor can be increased.

As discussed above, the present invention provides a clearance between the end of the insulating film layer of the lower board and a wall face of the cavity, whereby the upper board can be prevented from deflecting. The coplanarity of the cavity can be thus improved, which eases design restrictions on positioning a conductive hole (hereinafter referred to as a "via") and a connection land. As a result, components including semiconductors can be mounted efficiently, and a yield rate of the step of mounting the components can be advantageously improved.

### Brief Description of Drawings

Fig. 1A is a sectional view illustrating a method for manufacturing circuit boards in accordance with an embodiment of the present invention.
Fig. 1B is a sectional view illustrating a method for manufacturing circuit boards in accordance with an embodiment of the present invention.
Fig. 1C is a sectional view illustrating a method for manufacturing circuit boards in accordance with an embodiment of the present invention.
Fig. 1D is a sectional view illustrating a method for manufacturing circuit boards in accordance with an embodiment of the present invention.
Fig. 1E is a sectional view illustrating a method for manufacturing the circuit boards in accordance with an embodiment of the present invention.
Fig. 2A is a sectional view illustrating a method for manufacturing circuit boards in accordance with an embodiment of the present invention.
Fig. 2B is a sectional view illustrating a method for manufacturing circuit boards in accordance with an embodiment of the present invention.
Fig. 3A is a sectional view outlining an essential part of a circuit board in accordance with an embodiment of the present invention.
Fig. 3B is a sectional view outlining an essential part of a circuit board in accordance with an embodiment of the present invention.
Fig. 4A is a sectional view illustrating a method for manufacturing an upper board in accordance with an embodiment of the present invention.
Fig. 4B is a sectional view illustrating a method for manufacturing an upper board in accordance with an embodiment of the present invention.
Fig. 4C is a sectional view illustrating a method for manufacturing an upper board in accordance with an embodiment of the present invention.
Fig. 4D is a sectional view illustrating a method for manufacturing an upper board in accordance with an embodiment of the present invention.
Fig. 4E is a sectional view illustrating a method for manufacturing an upper board in accordance with an embodiment of the present invention.
Fig. 4F is a sectional view illustrating a method for manufacturing an upper board in accordance with an embodiment of the present invention.
Fig. 5A is a sectional view illustrating a method for manufacturing an upper board in accordance with an embodiment of the present invention.
Fig. 5B is a sectional view illustrating a method for manufacturing an upper board in accordance with an embodiment of the present invention.
Fig. 5C is a sectional view illustrating a method for manufacturing an upper board in accordance with an embodiment of the present invention.
Fig. 6A is a sectional view illustrating a method for manufacturing a lower board in accordance with an embodiment of the present invention.
Fig. 6B is a sectional view illustrating a method for manufacturing a lower board in accordance with an embodiment of the present invention.
Fig. 6C is a sectional view illustrating a method for manufacturing a lower board in accordance with an embodiment of the present invention.
Fig. 6D is a sectional view illustrating a method for manufacturing a lower board in accordance with an embodiment of the present invention.
Fig. 7A is a sectional view illustrating a method for manufacturing a connecting sheet in accordance with an embodiment of the present invention.
Fig. 7B is a sectional view illustrating a method for manufacturing a connecting sheet in accordance with an embodiment of the present invention.
Fig. 7C is a sectional view illustrating a method for manufacturing a connecting sheet in accordance with an embodiment of the present invention.
Fig. 7D is a sectional view illustrating a method for manufacturing a connecting sheet in accordance with an embodiment of the present invention.
Fig. 7E is a sectional view illustrating a method for manufacturing a connecting sheet in accordance with an embodiment of the present invention.
Fig. 7F is a sectional view illustrating a method for manufacturing a connecting sheet in accordance with an embodiment of the present invention.
Fig. 7G is a sectional view illustrating a method for manufacturing a connecting sheet in accordance with an embodiment of the present invention.
Fig. 7H is a sectional view illustrating a method for manufacturing a connecting sheet in accordance with an embodiment of the present invention.
Fig. 8A is a sectional view of a conventional circuit board.
Fig. 8B is a sectional view of a conventional circuit board.
Fig. 9A is a sectional view illustrating problems of a conventional circuit board and a method for manufacturing the conventional circuit board.
Fig. 9B is a sectional view illustrating problems of a conventional circuit board and a method for manufacturing the conventional circuit board.

### Preferred Embodiments for Carrying out the Invention

### Exemplary Embodiment 1

In this embodiment, a basic structure of a circuit board in accordance with the embodiment is described, and then structural elements of the circuit board and other examples are described.

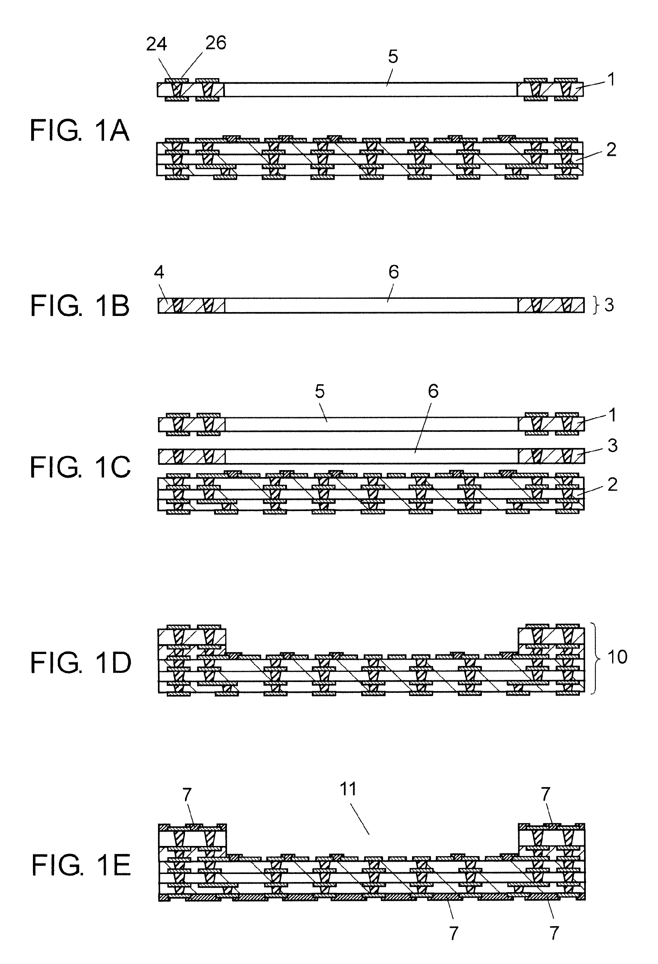

Fig. 1E is a sectional view of the circuit board in accordance with this embodiment. This circuit board is formed by overlaying upper board 1 formed of laminated board and having cavity 11 on lower board 2 formed of laminated board.

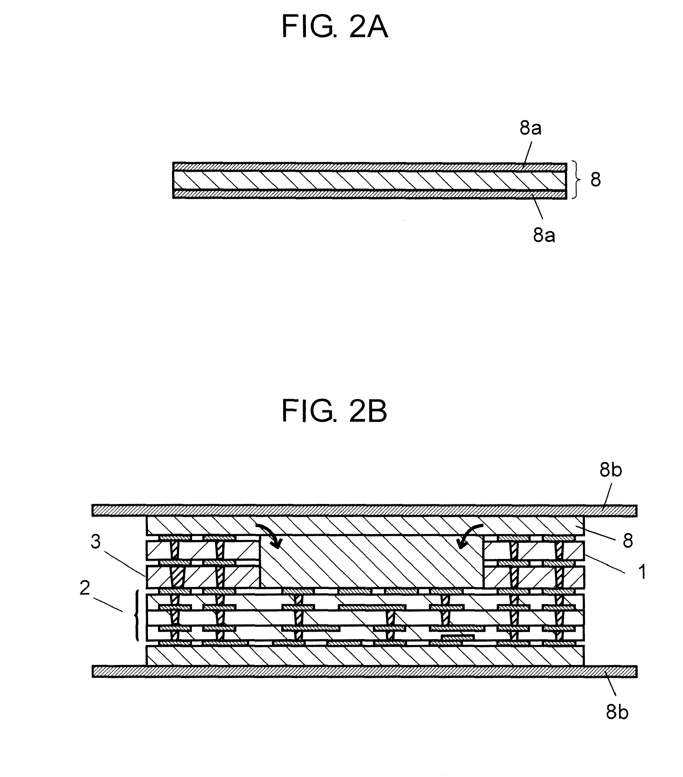

First, a basic manufacturing process is described with reference to Figs. 1A- 1E, and Figs. 2A- 2B. Figs. 1A- 1E are sectional views illustrating a method for manufacturing the circuit board in accordance with this embodiment.

As shown in Fig. 1A, upper board 1 and lower board 2 both having a circuit on their surfaces are formed. Both the boards have through-holes 23 filled with conductive paste 24, i.e. vias, and the circuits formed on the respective surfaces are connected together through these vias.

Next, as shown in Fig. 1B, inter-board connecting sheet 3 having a through-hole filled with conductive paste 24 is formed. At this moment, insulating resin of sheet 3 is semi-cured. This state is referred to as "stage B" hereinafter.

Upper board 1 and inter-board connecting sheet 3 include opening 5 and opening 6 respectively, and these openings have predetermined areas at the centers of board 1 and sheet 3. Sheet 3 includes bonding layer 4 and is made of material different from upper board 1 or lower board 2. Sheet 3 includes vias formed by filling conductive paste in through-holes punched in the board material kept in stage B. Sheet 3 thus can bond the boards together and electrically connect the layers together.

The structures of upper board 1, lower board 2, and inter-board connecting sheet 3 are detailed later, and the methods for forming them are also detailed later.

Next, as shown in Fig. 1C, the lower board 2, inter-board connecting sheet 3, and upper board 2 are layered one after another in this order, and then heat and pressure (vacuum thermal press) are applied to the layered unit for molding and curing this unit. Lower board 2 is thus bonded to upper board 2 via inter-board connecting sheet 3, whereby multi-layer circuit board 10 shown in Fig. 1D is formed. Opening 5 of board 1 and opening 6 of sheet 3 are positioned at approximately the same place vertically, and these openings have approximately the same sizes and form cavity 11 of circuit board 10.

Next, as shown in Fig. 1E, solder-resist 7 is selectively formed on circuit board 10 except parts of circuit patterns such as connecting electrodes on the surface of upper board 1. This solder-resist 7 works as insulating film layer. Then exposed conductors with nickel-plating and gold-plating are provided. In other words, form the insulating film layer selectively on the surfaces of board 1 and board 2 except for parts of the surfaces thereof, and then form the gold-plated layer on the exposed surfaces.

In the forgoing instance, solder-resist 7 is formed on upper board 1 following the step shown in Fig. 1E; however, it can be formed following a preparatory step shown in Fig. 1A. This will be detailed later.

The step of applying heat and pressure (thermal press) shown in Fig. 1C is preferably done by pinching, in particular, upper board 1 with SUS board 8b shown in Fig. 2B via cushion member 8 shown in Fig. 2A because of the presence of openings 5 and 6.

Cushion member 8 preferably has fluidity lower than that of the resin of sheet 3 kept in stage B. Silicone rubber or butyl rubber is good for cushion member 8 because these rubbers include mold releasing layer 8a in the surface layer.

The foregoing cushion member 8 becomes fluid during the step shown in Fig. 1C, i.e. a vacuum thermal press machine rises in temperature, and then cushion member 8 is pressed and poured into voids (cavity 11) of openings 5 and 6. Cushion member 8 thus presses the entire surface of the layered unit uniformly. A cushion member formed of fluid material can be used between mold releasing layer 8 and the silicone rubber or the butyl rubber. A form with a projection of which volume is approximately the same as that of openings 5 and 6 can be used for applying heat and pressure.

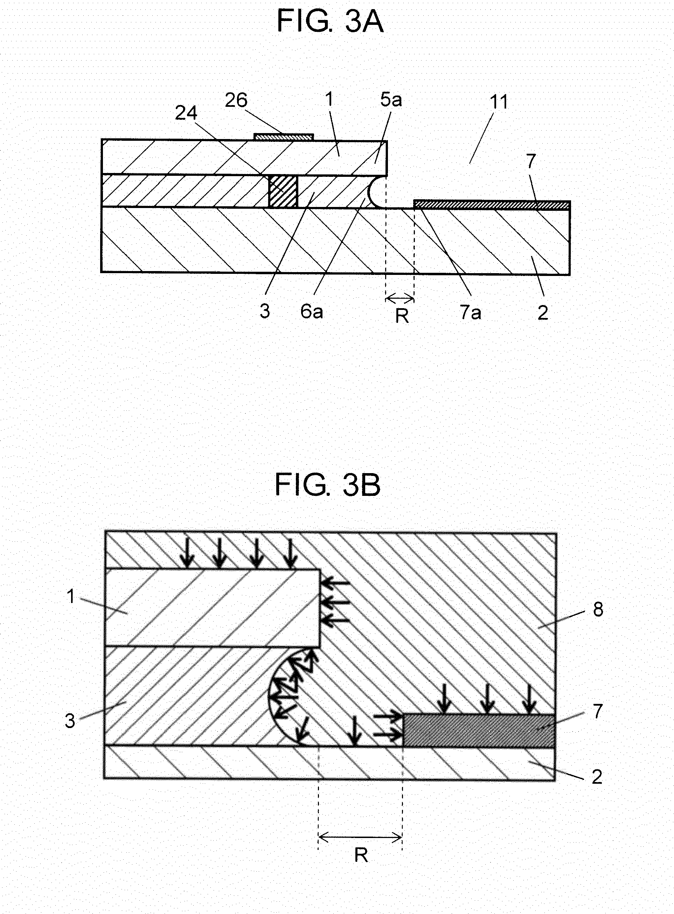

Fig. 3A is a sectional view outlining an essential part of the method for manufacturing the circuit board in accordance with this embodiment. As shown in Fig. 3A, solder-resist 7 working as the insulating film layer is formed such that clearance R can be available between an end of solder-resist 7 and end 5a of opening 5 or end 6a of opening 6. In other words, clearance R is provided between end 7a of solder-resist 7 and the wall face of cavity 11.

The method for manufacturing the circuit board in accordance with this embodiment includes the step of applying heat and pressure, and during this step, cushion member 8 is input in clearance R, as shown in Fig. 3B which schematically details an essential part. In Fig. 3B, the arrows indicate the pressure produced by cushion member 8 and applied to upper board 1, lower board 2, inter-board connecting sheet 3, and solder-resist 7.

As shown in Fig. 3B, the formation of solder-resist 7 produces a space on the bottom of cavity 11, and this space allows cushion sheet to enter up to the wall face of the bottom. As a result, the flow-out of the resin from inter-board connecting sheet 3 can be suppressed, and the shape can be regulated, whereby reaction force component (shown with arrows) is produced against the deflection or deformation of upper board 1 for suppressing the deflection of cavity 11.

An area of opening 6 of sheet 3 is preferably greater than that of opening 5 of upper board 1. Both of the openings form the wall face of cavity 11. An adjustment of the area of opening 6 of sheet 3 and an adjustment of clearance R formed by solder-resist 7 will allow adjusting an amount of the cushion sheet entering onto the bottom of cavity 11, and also regulating a height of cavity 11.

On top of that, the foregoing clearance R can be provided selectively. To be more specific, in the case where circuit patterns are wired on lower board 2 just under end 6a of sheet 3 and upper board 1, solder-resist 7 is needed for covering the circuit patterns. In such a case, solder-resist 7 is formed on the circuit patterns and their vicinity only, and clearance R is formed at places where no circuit patterns exist. This structure allows obtaining an advantage similar to what is discussed above. The foregoing adjustments on design basis allow eliminating the deflection or deformation.

### (1) Description of Upper Board 1

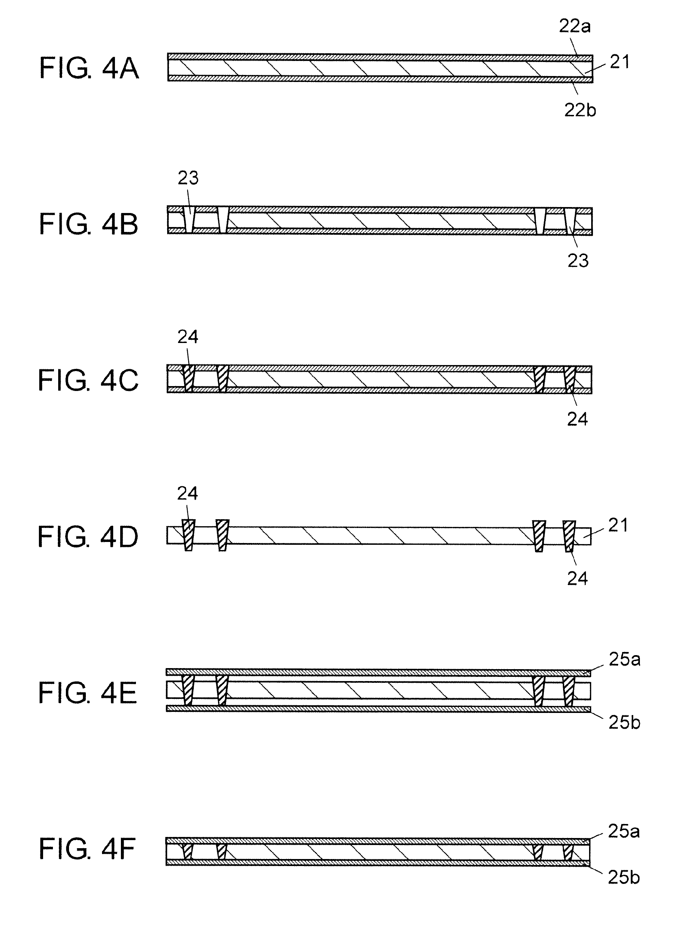

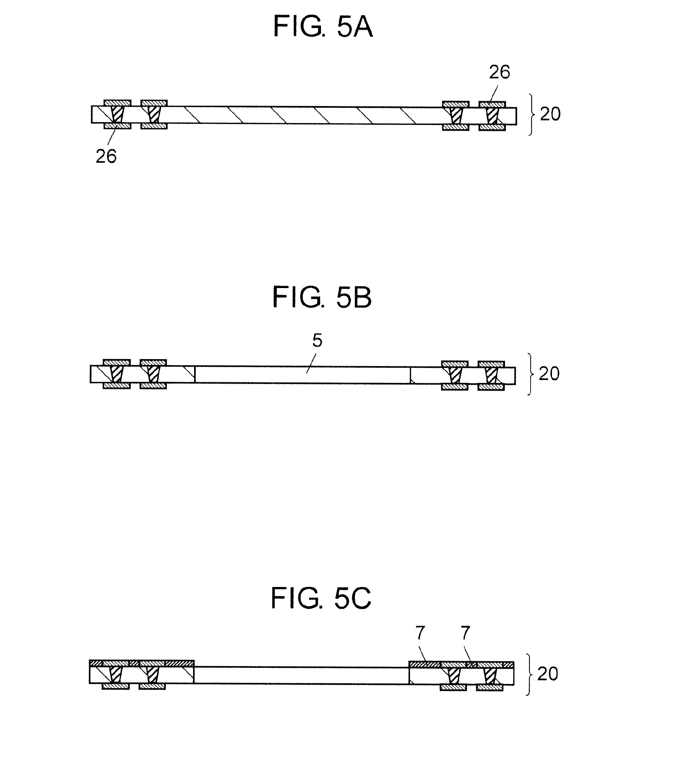

The structure and process of upper board 1 used in the step shown in Fig. 1A are described hereinafter. Figs. 4 and 5 are sectional views illustrating a method for manufacturing the upper board in accordance with this embodiment.

First, in Fig. 4A, prepreg sheet 21 (hereinafter simply referred to as prepreg 21) is used as board material. Prepreg 21 is kept in a state of stage B and has dimensions of 300x250 mm with depth of approximately 100 µm. Prepreg 21 is made of compound material, e.g. glass woven fabric impregnated with thermosetting epoxy resin, and is used for a printed circuit board called mother board. Prepreg 21 is provided with mold releasing films 22a and 22b on respective sides. Each one of these films is formed of plastic sheet having a thickness of approximately 12 µm, and Si-based mold release agent is applied to one side of the plastic sheet. Mold releasing films 22a and 22b employ, e.g. poly ethylene terephthalate.

Next, as shown in Fig. 4B, through-holes 23 are formed on prepreg 21 provided with mold releasing films 22a and 22b on respective sides at given places by a laser machining method. Then as shown in Fig. 4C, through-holes 23 are filled with conductive paste 24 by printing conductive paste 24 directly on films 22a and 22b with a printing machine (not shown). Mold releasing films 22a and 22b thus work as print-mask and also work for preventing the surface of prepreg 21 from contamination.

Next, as shown in Fig. 4D, films 22a and 22b are peeled off from both sides of prepreg 21, and then as shown in Fig. 4E, prepreg 21 is layered between metal foils 25a and 25b. Next, as shown in Fig. 4F, heat and pressure are applied to the entire surface by a thermal press method for curing prepreg 21. At this time, conductive paste 24 is compressed, whereby metal foils 25a and 25b on the respective sides are electrically connected together.

Next, as shown in Fig. 5A, metal foils 25a and 25b, e.g. copper foil, are selectively etched, thereby obtaining two-layer circuit board 20 provided with circuit pattern 26. Then as shown in Fig. 5B, an opening 5 having a given area (10 mm×10 mm) at a place including the center of circuit board 20. Opening 5 can be formed by: cutting by a laser machining method after the step of selective etching on metal foils 25a and 25b, punching out with a tooling die, or eliminated by a router machining method with an end mill.

Circuit board 20 provided with opening 5 as shown in Fig. 5B can be used as upper board 1 in the step shown in Fig. 1A; however, it is more preferable to use a board provided with solder-resist 7 as an insulating film layer as shown in Fig. 5C as upper board 1. Use of this board instead of circuit board 20 allows forming the solder- resist on upper board 1 kept in a plane state, so that an easier step of manufacturing as well as more efficient productivity can be expected.

### (2) Description of Lower Board 2

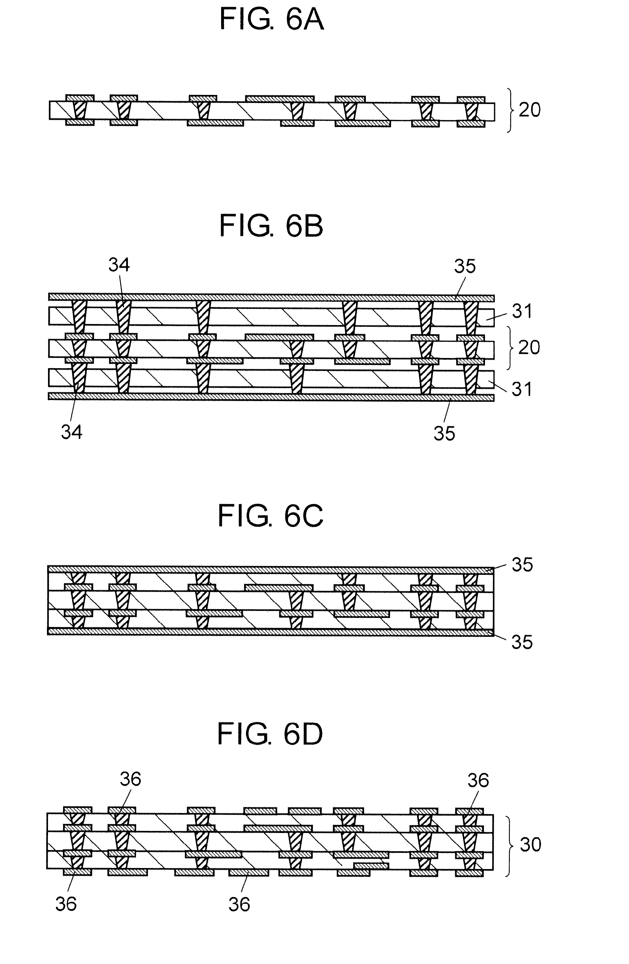

The structure and process of lower board 2 used in the step shown in Fig. 1A are described hereinafter. Figs. 6A- 6D are sectional views illustrating a method for manufacturing the lower board in accordance with this embodiment.

First, as shown in Fig. 6A, two-layer circuit board 20 formed by the steps shown in Figs. 4A- 4F and Figs. 5A- 5C is prepared. Then two sheets of prepreg 31 shown in Fig. 4D and two sheets of metal foil 35 are prepared. Prepreg 31 is kept in a state shown in Fig. 4D and has been formed by the steps shown in Figs. 4A- 4D. As shown in Fig. 6B, metal foil 35 and prepreg 31 are placed at a positioning stage (not shown), and then circuit board 20 is layered thereon as a core board for inner layer. On top of that, prepreg 31 and metal foil 35 are further layered on the foregoing layered unit, and the resultant layered unit is tentatively bonded together to form a layered structure.

Next, as shown in Fig. 6C, heat and pressure are applied to the entire surface of the foregoing layered structure by the thermal press method, thereby molding and curing the layered structure. Then prepreg 31, metal foil 35 and circuit board 20 are bonded together to form a multi-layer structure. At this time, conductive paste 34 is compressed, so that metal foil 35 on both sides can be electrically connected to circuit board 20 inside the multi-layer structure with conductive paste 34. Next, as shown in Fig. 6D, metal foil 35 is selectively removed by etching, thereby forming circuit pattern 36.

Next, solder-resist 7 working as an insulating film layer is formed inside the opening of upper board 1 and on the bottom of cavity, i.e. on the upper side of lower board 2. This step is detailed with reference to Fig. 3B which schematically illustrates an essential part of this step.

Solder-resist 7 to be used in this embodiment is formed by the step, shown in Fig. 1C, of applying heat and pressure such that clearance R can be formed between end 7a of solder-resist 7 closer to an end of the opening and end 5a of opening 5 of upper board 1 or end 6a of opening 6 of inter-board connecting sheet 3 as shown in Fig. 3A. In other words, solder-resist 7 working as an insulating film layer of lower board 2 can be formed such that clearance R is available between its end 7a and end 5a of opening 5 of upper board 1 or end 6a of opening 6 of sheet 3. Solder-resist 7 is thus preferably formed using end 5a of opening 5 of upper board 1 as a reference.

If end 6a of opening 6 of sheet 3 is used as the reference, clearance R is obliged to be narrower because the resin flows out from end 6a of sheet 3 having undergone the step of thermal press shown in Fig. 1C. In this case, a greater area of opening 6 of sheet 3 than that of opening 5 of upper board 1 will achieve a desirable clearance R.

The greater area of opening 6 of sheet 3 than that of opening 5 of upper board 1 will produce a space in addition to the space of clearance R. These spaces allow forming a flow-path for mold resin on the bottom of cavity, so that moisture absorption from the outside can be prevented. This structure thus enhances the electrical insulation in a state of high temperature and high humidity, so that higher reliability in mounting semiconductors can be expected.

When a multilayer board having four layers or more is manufactured, the circuit board having four layers or more is used as a core board for inner layers, and the steps discussed above can be repeated.

A both-sided board having a circuit on its surfaces or a multi-layer circuit board (including the circuit board of the present invention) is layered one after another via prepeg having through holes filled with conductive paste, i.e. vias, for inter-layer connection, thereby forming a multi-layer circuit board.

A circuit board having a circuit on its surface can be connected with circuit board 20 working as a core board and existing at an inner layer through vias formed by conductive plating. The inner board working as the core board can be formed by connecting the surface to the rear face or by inter-layer connection through the vias formed by conductive plating. Use of the boards having through-holes or plated through-holes will enhance heat dissipation performance.

### (3) Description of inter-board connecting sheet 3

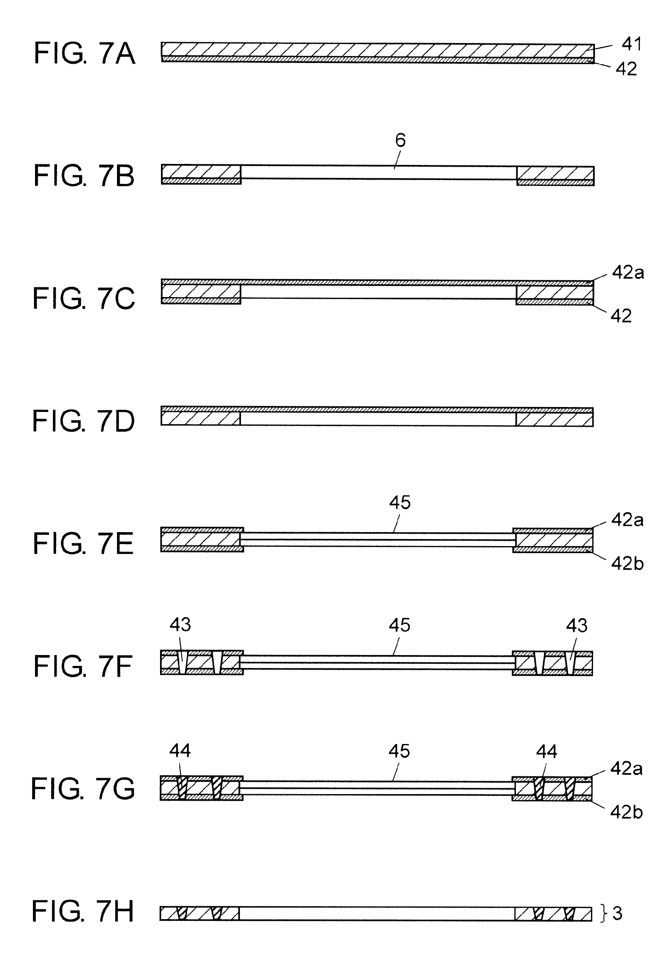

The structure and process of inter-board connecting sheet 3 used in the step shown in Fig. 1B are described hereinafter. Figs. 7A- 7H are sectional views illustrating a method for manufacturing this sheet 3 in accordance with this embodiment. As shown in Fig. 7A, a sheet member formed of carrier film 42, on which organic bonding layer 41 of approximately 100 µm thick is formed, is prepared. This sheet member has dimensions of 300 x 250 mm. The thickness of bonding layer 41 can be selected from the range of 30- 300 µm depending on a height of component mounted on the board. In this embodiment, bonding layer 41 has the thickness of 100 µm.

The sheet member employs polyethylene terephthalate (PET) as carrier film 42, and thermosetting resin filled with filler at a high content as bonding layer 41. To be more specific, bonding layer 41 is formed by mixing inorganic powder such as silica or alumina, working as filler, with epoxy resin of 55- 90 wt%. Glass woven fabric is not used here as core member.

The foregoing structure allows the sheet member in accordance with this embodiment to have lower thermal expansion coefficients in the directions of width, depth and thickness than those of regular glass epoxy layered board. Expansion coefficient α1 is 12 ppm/°C in the thickness direction in particular at a lower temperature than the glass transition temperature. On the other hand, the prepreg sheet made of glass-cloth epoxy resin and used as the material for upper board 1 and lower board 2 has the expansion coefficient α1 of 65 ppm/°C in the thickness direction. Since the sheet member is filled with filler at the high content, it has a low fluidity. To maintain this low fluidity, rubber based material can be mixed in to the sheet member upon necessity.

Next, as shown in Fig. 7B, opening 6 having a given area is formed at a place including the center. It is preferable to form opening 6 during the presence of carrier film 42 because of easier handling in the manufacturing step.

It is also preferable to form opening 6 by cutting the sheet member with the laser machining method rather than by using a punching machine and a die. In this embodiment, bonding layer 41 is chiefly made of epoxy resin and includes filler such as silica or alumina at 55 wt% or more. In this case, it is preferable to use carbon dioxide laser having a wavelength of 9.4- 10.6 µm. This method allows preventing the resin at the cut surface from flowing. The preventing mechanism is this: The laser machining energy is absorbed into the filler of bonding layer 41, and is transformed to heat, which then denatures the epoxy. The filler as a core and denatured epoxy resin form an altered layer along the cut surface. This altered layer prevents the resin from flowing from the cut surface.

The resin thus can be prevented from flowing out from the end face of inter-board connecting sheet 3 during the step shown in Fig. 1D, i.e. the step of applying heat and pressure. On top of that, deformation such as collapse of vias, i.e. conductive holes, can be prevented. The structure discussed above thus maintains or enhances the electric insulation in the state of high temperature and high humidity. The structure also prevents the filler or the resin component from dropping from the end face of opening 6, so that no waste is produced.

The area of opening 6 is preferably greater than that of opening 5 formed on upper board 1 in the step shown in Fig. 5B. In a case where opening 5 is a square of which one side is A mm long, then opening 6 is preferably a square of which one side is (A+a) mm long, and the value of "a" is set at 0.5- 1.0% of the value of A. For instance, when opening 5 is a square having a 10 mm long side, then opening 6 is formed such that its one side can be greater than that of opening 5 by 50- 100 µm. This structure allows maintaining a clearance for the flow-out of the resin from inter-board connecting sheet 3, and also allows fitting solder-resist 7 formed on end 5a of opening 5 of upper board 1 to opening 6, so that the resin of sheet 3 can be prevented from flowing out.

Next, as shown in Fig. 7C, mold-releasing film 42a is laminated on the sheet member at the opposite face to carrier film 42. Mold releasing film 42a can be also laminated on the entire surface including carrier film 42. Mold releasing film 42a is a plastic sheet on which one side is coated with silicon-based mold releasing agent in approximately 12 µm thick. This plastic sheet employs, e.g. polyethylene terephthalate.

Next as shown in Fig. 7D, carrier film 42 is peeled off, and then as shown in Fig. 7E, mold releasing film 42b is laminated on a face, from which carrier film 42 has been removed, in vacuum state with a vacuum laminating device. These procedures form a contact section 45 where mold releasing films 42a and 42b touch with each other.

The vacuum laminating device includes a laminate-roll (not shown) which laminates mold-releasing films 42a, 42b onto the sheet member while heat and pressure are applied to films 42a and 42b. At this time, since the lamination is done in a vacuum, contact section 45 of the mold-releasing member sinks into opening 6, and this contact section does not receive heat or pressure from the laminate-roll but film 42a and film 42b are brought into contact with each other to form contact section 45 only by a vacuum pressure. This structure allows films 42a and 42b to be removed with ease from the sheet member in the step shown in Fig. 7H.

The presence of contact section 45 at opening 6 enhances rigidity of bonding layer 41. The higher rigidity allows the sheet member to be handled with ease during the step of laser piercing or the step of filling the paste into the holes.

The foregoing discussion shows an instance of using the vacuum laminating device equipped with the laminate-roll; however, the mold releasing film can be laminated on the sheet member by using a vacuum pressing device. In this case, the lamination in a vacuum will also allow forming contact section 45 at opening 6.

In the step shown in Fig. 7D, carrier film 42 is temporarily removed, and then mold releasing film 42b is laminated on the sheet member in the step shown in Fig. 7E. This procedure intends to form contact section 45. In addition to the easier handling of the sheet member as discussed above, an optimum condition for the laser piercing step can be obtained because films 42a and 42b made of the same material of the sheet member are laminated on both the faces of the sheet member.

Next, as shown in Fig. 7F, through-holes 43 are formed by the laser machining method on the region except opening 6, and then as shown in Fig. 7G, through-holes 43 are filled with conductive paste 44 by the same method as shown in Fig. 4C. Next, as show in Fig. 7H, mold-releasing films 42a and 42b are removed from both sides of the sheet member, thereby completing inter-board connecting sheet 3.

The foregoing description details an instance of layering upper board 1 onto lower board 2 via inter-board connecting sheet 3 with reference to Fig. 1; however, alternative methods are possible.

In one alterative method: Only the mold releasing film 42b on the rear side of sheet 3 is removed, but film 42a on the front side is kept as it is. Sheet 3 of this state is prepared, and the opposite face to the front face, where film 42a is kept being laminated, is used as a contact face with lower board 2, and the opposite face is positioned and layered onto lower board 2 with multiple tentative bonding points, and then lamination in a vacuum is done for tentative bonding all over the face.

Inter-board connecting sheet 3 in accordance with this embodiment has low fluidity and high rigidity, so that only the multiple tentative bonding points will cause positional deviation during the step of thermal press; however, use of the foregoing another method will prevent the positional displacement. The presence of mold-releasing film 42a allows maintaining the conductive paste filled in the holes and allows the entire face of inter-board connecting sheet 3 including opening 6 to be bonded tentatively to lower board 2 uniformly. Mold-releasing film 42a is then removed, and upper board 1 is layered on sheet 3. This layered unit then undergoes the same steps shown in Fig. 1D and onward, thereby completing the circuit board.

The circuit board manufactured by the foregoing method thus has an IVH (Inner Via Hole) structure throughout the layers and includes cavity 11 where electronic components can be mounted, and on top of that, this circuit board can be mounted to a motherboard such as a multiplayer printed circuit board. Upper board 1 and lower board 2 of the circuit board in accordance with this embodiment can be formed of the same material as that of the motherboard. Inter-board connecting sheet 3 that connects board 1 and board 2 together is made of the material of which thermal expansion coefficient along the thickness direction is lower than those of board 1 and board 2, so that warping of sheet 3 can be suppressed. The reliability in mounting the circuit board to the motherboard can be thus improved.

Since inter-board connecting sheet 3 is made of the material of low fluidity, the resin can be prevented from flowing out inside cavity 11, and the deformation of conductive holes due to fluid resin can be prevented. As a result, the IVH structure throughout the layers can obtain higher reliability in the inter-layer connection.

The method for manufacturing the circuit board in accordance with the embodiment can form recessed cavity 11 easily and efficiently without employing the step of baking, counter sinking, or resin molding, and can provide the circuit board of which height can be adequate to the height of electronic components mounted to cavity 11 without changing the mold die.

In this embodiment, two-layer circuit board 20 is used as upper board 1, and four-layer circuit board 30 is used as lower board 2; however, the number of layers for board 1 and board 2 is not limited to this instance. Upper board 1 and lower board 2 are made by curing the glass woven fabric impregnated with epoxy resin; however, the base material is not limited to the glass woven fabric, and non-woven fabric such as aramid can be used instead. The resin to be used for impregnation is not limited to the epoxy resin. It can be selected from a variety of resin in response to the specification of the circuit board as long as its structure meets the intention of the present invention in comparing the thermal expansion coefficient along the thickness direction with that of the material used in the inter-board connecting sheet.

The insulating film layer formed selectively on the surfaces of the upper board and the lower board employs the solder-resist to be used in photo development; however, the material can be an insulating film material to be used in component layout, and the film is not limited to the photo development application but it can be a photosensitive film. Use of a metal sheet or a screen, of which ink-transmissian hole has a trapezoid sectional view, allows forming a raised insulating film layer by a certain printing method.

The step, discussed previously, of layering materials such as a board, metal foil, and sheet includes a step of applying heat and pressure with a heating device for tentatively bonding those materials together after layering positioning marks (or holes) are layered with a recognition device such as CCD onto the materials or board placed on the positioning stage. This step of tentative bonding was omitted for making the description simple.

It is preferable to employ lower board 2 of which thermal expansion coefficient is approximately the same as that of upper board 1 including opening 5. This structure allows further suppressing the deformation (vias collapse) of the conductive holes formed on sheet 3. To be more specific, a copper remaining rate, number of layers, and thickness of upper board 1 or lower board 2 can be set appropriately in response to the area of opening 5, whereby approximately the same thermal expansion coefficient can be achieved.

Bonding layer 4 can employ thermoplastic resin, e.g. polyphenylene sulfide (PPS), polyetheretherketon(PEEK), polyethersulfon (PES), or thermoplastic polyimide as long as those materials have an expansion coefficient equal to or lower than that of bonding layer 4 of the inter-board connecting sheet or as long as those materials can undergo the laser machining or inter-layer bonding.

### Industrial Applicability

The present invention aims to meet recent demands of a circuit board to have a greater number of layers and higher density. The circuit board of the present invention can be an alternative circuit board to the conventional LTCC (Low Temperature Co-fired Ceramics) circuit board, and this alternative circuit board assures that the productivity, reliability and manufacturing cost are better than those of the conventional circuit board. The circuit board of the present invention is suitable to be mounted to a motherboard which is formed by layering glass epoxy resin into a multiplayer printed circuit board. The present invention can be thus used in wide range applications.

### Description of Reference Signs

1, 61 upper board
2 lower board
3 inter-board connecting sheet
4, 41, 63 bonding layer
5, 6, 9 opening
5a, 6a end
7 solder-resist
8 cushion member
8a mold releasing layer
8b SUS board
10, 20, 30 circuit board
11 cavity
21, 31 prepreg sheet
22a, 22b, 42a, 42b mold releasing film
23, 43 through-hole
24, 34, 44 conductive paste
25a,25b,35 metal foil
26, 36 circuit pattern
42 carrier film
45 contact section
50 green sheet
51 mold resin layer
52 board
55 opening

## Claims

1. A method for manufacturing a circuit board, the method comprising the steps of:
forming an upper board having an opening, and provided with a circuit and an insulating film layer formed on a surface thereof;
forming a lower board provided with a circuit and an insulating film layer formed on a surface thereof;
forming an inter-board connecting sheet having a through-hole filled with a conductive paste; and
layering the lower board, the inter-board connecting sheet and the upper board together, and applying heat and pressure,
wherein the step of forming the lower board includes a step of forming the insulating film layer into a shape leaving a clearance provided between an end of the film layer and any of an end of the opening of the upper board and an end of an opening of the inter-board connecting sheet when the lower board, the inter-board connecting sheet and the upper board are layered together, and
the step of applying heat and pressure includes a step of inserting a cushion member into the openings of the inter-board connecting sheet and the upper board and into the clearance.

2. The manufacturing method of claim 1, wherein an area of the opening of the inter-board connecting sheet is greater than that of the opening of the upper board.

3. The manufacturing method of claim 1, wherein the upper board and the lower board include a base material having a resin impregnated and cured, and
the inter-board connecting sheet includes a bonding layer formed on a carrier film, and the bonding layer includes an inorganic filler and a thermosetting resin without including a core member.

4. The manufacturing method of claim 1, wherein a thermal expansion coefficient along a thickness direction of a material of the inter-board connecting sheet is smaller than those in thickness directions of materials of the upper board and the lower board.

5. The manufacturing method of claim 1, wherein the step of forming the upper board includes a step of providing a conductive hole having a through-hole filled with a conductive paste,
the step of forming the lower board includes a step of providing a conductive hole having a through-hole filled with a conductive paste, and
connecting the circuits on both the surfaces via the conductive holes.

6. The manufacturing method of claim 1, wherein during the step of forming the inter-board connecting sheet, the sheet is kept in a state of stage B, and the cushion member has a fluidity lower than that of the sheet.

7. The manufacturing method of claim 6, wherein the cushion member includes any of a silicone rubber and a butyl rubber provided with a mold releasing layer on a surface thereof.

8. A circuit board comprising:
an upper board having an opening, and provided with a circuit and an insulating film layer on a surface thereof;
a lower board provided with a circuit and an insulating film layer on a surface thereof; and
an inter-board connecting sheet having an opening and a conductive hole for inter-layer connection,
wherein the upper board and the lower board are layered together via the inter-board connecting sheet, and a cavity is formed by the opening of the upper board and the opening of the inter-board connecting sheet, and an area of the opening of the sheet is greater than that of the opening of the upper board, and a clearance is provided between an end of the insulating film layer of the lower board and an end of the opening of the sheet.

9. The circuit board of claim 8, wherein the upper board and the lower board are formed of a base material having a resin impregnated and cured, and the inter-board connecting sheet is formed of a bonding layer including an inorganic filler and a thermosetting resin without including a core member, the thermosetting resin is cured.

10. The circuit board of claim 8, wherein a thermal expansion coefficient along a thickness direction of a material of the inter-board connecting sheet is smaller than those in thickness directions of materials of the upper board and the lower board.

## Amended claims

### Amended claims under Art. 19.1 PCT

**1.** (Amended) A method for manufacturing a circuit board, the method comprising the steps of:
forming an upper board having an opening, and provided with a circuit and an insulating film layer formed on a surface thereof;
forming a lower board provided with a circuit and an insulating film layer formed on a surface thereof;
forming an inter-board connecting sheet having a through-hole filled with a conductive paste; and
layering the lower board, the inter-board connecting sheet and the upper board together, and applying heat and pressure,
wherein the step of forming the lower board includes a step of forming the insulating film layer into a shape leaving a clearance provided between an end of the film layer and any of an end of the opening of the upper board and an end of an opening of the inter-board connecting sheet when the lower boards, the inter-board connecting sheet and the upper board are layered together, a width of the clearance being set with reference to the end of the opening of the upper board, and
the step of applying heat and pressure includes a step of inserting a cushion member into the openings of the inter-board connecting sheet and the upper board and into the clearance where a space is formed.

**2.** The manufacturing method of claim 1, wherein an area of the opening of the inter-board connecting sheet is greater than that of the opening of the upper board.

**3.** The manufacturing method of claim 1, wherein the upper board and the lower board include a base material having a resin impregnated and cured, and
the inter-board connecting sheet includes a bonding layer formed on a carrier film, and the bonding layer includes an inorganic filler and a thermosetting resin without including core member.

**4.** The manufacturing method of claim 1, wherein a thermal expansion coefficient along a thickness direction of a material of the inter-board connecting sheet is smaller than those in thickness directions of materials of the upper board and the lower board.

**5.** The manufacturing method of claim 1, wherein the step of forming the upper board includes a step of providing a conductive hole having a through-hole filled with a conductive paste,
the step of forming the lower board includes a step of providing a conductive hole having a through-hole filled with a conductive paste, and
connecting the circuits on both the surfaces via the conductive holes.

**6.** The manufacturing method of claim 1, wherein during the step of forming the inter-board connecting sheet, the sheet is kept in a state of stage B, and the cushion member has a fluidity lower than that of the sheet.

**7.** The manufacturing method of claim 6, wherein the cushion member includes any of a silicone rubber and a butyl rubber provided with a mold releasing layer on a surface thereof.

**8.** (Amended) A circuit board comprising:
an upper board having an opening and provided with a circuit and an insulating film layer on a surface thereof;
a lower board provided with a circuit and an insulating film layer on a surface thereof; and
an inter-board connecting sheet having a conductive hole for interlayer connection and an opening,
wherein the upper board and the lower board are layered together via the inter-board connecting sheet, and a cavity is formed by the opening of the upper board and the opening of the inter-board connecting sheet, and an area of the opening of the sheet is greater than that of the opening of the upper board, and a clearance is provided between an end of the insulating film layer of the lower board and an end of the opening of the sheet for providing a space as a flow-path of a mold resin.

**9.** The circuit board of claim 8, wherein the upper board and the lower board are formed of a base material having a resin impregnated and cured, and the inter-board connecting sheet is formed of a bonding layer including an inorganic filler and a thermosetting resin without including core member, the thermosetting resin is cured.

**10.** The circuit board of claim 8, wherein a thermal expansion coefficient along a thickness direction of a material of the inter-board connecting sheet is smaller than those in thickness directions of materials of the upper board and the lower board.
